# EUROPÄISCHE PATENTANMELDUNG

(11) **EP 0 735 695 A2**
(43) Veröffentlichungstag der Anmeldung: **02.10.1996**
(21) Anmeldenummer: 96104481.5
(22) Anmeldetag: 21.03.1996
(51) Int. Cl.: H03M 13/00

(54) **Viterbi-Dekodiereinrichtung mit Prozessor und mit Addier- Vergleichs- und Auswahlschaltung**

(30) Priorität: 25.03.1995 DE 19511015
(71) Anmelder: Alcatel SEL Aktiengesellschaft, D-70435 Stuttgart (DE)
(72) Erfinder: Schütz, Thomas, 76275 Ettlingen (DE); Sulzberger, Uwe, 70563 Stuttgart (DE)
(74) Vertreter: Knecht, Ulrich Karl, Dipl.-Ing.

(57) **Zusammenfassung**

Es wird eine Schaltung (DHW) vorgeschlagen, die in Verbindung mit einem Prozessor (DSP) den Viterbi-Algorithmus in einem Nachrichtenempfänger, insbesondere Funkempfänger, durchführt.

Dazu enthält die Schaltung (DHW) Speichermittel (IN, OUT) zum Speichern von Eingangsdaten, die der Porzessor (DSP) vorgibt, und von Ausgangsdaten, auf die der Prozessor zugreift. Weiterhin enthält die Schaltung eine Logikschaltung (LGT), die mittels logischer Verknüpfungen der Eingangsdaten die Ausgangsdaten bildet. Eingangsdaten sind alte Metriken (OLM1, OLM2), die einen Zustand betreffen. Die Ausgangsdaten sind neue Metriken (NEM1, NEM2) und Differenzwerte (D1, D2), die den nachfolgenden Zustand betreffen und als sogenannte "Soft-Decision-Werte" für eine spätere prozessorgesteuerte Berechnung dienen. Weiterhin enthält die Schaltung ein als "Prestate-Buffer" ausgeführtes Schieberegister (PRST). Die Schaltung (DHW) ist im wesentlichen aus schnellen Logikgattern aufgebaut und entlastet den Prozessor (DSP), indem sie die sogenannten "Add-Compare-Select-Operationen" innerhalb des Viterbi-Algorithmus durchführt. Eine externe Taktversorgung für die Schaltung ist nicht erforderlich.

## Beschreibung

Die Erfindung betrifft eine Schaltung zur Durchführung eines ersten Teils des Viterbi-Algorithmus, wobei der erste Teil Addier-, Vergleichs- und/oder Auswahloperationen umfaßt, und eine Viterbi-Dekodiereinrichtung sowie einen Nachrichtenempfänger, die jeweils diese Schaltung enthalten.

Zur Reduzierung der Störempfindlichkeit einer Nachrichtenübertragung ist es bekannt, die übertragenen Nachrichtensignale mittels Faltungscodes beim Senden und beim Empfangen zu kodieren bzw. zu dekodieren. Zum Dekodieren von faltungskodierten Nachrichtensignalen wurde von A.J. Viterbi ein nach ihm benannter Algorithmus vorgestellt (s. IEEE Trans. Information Theory, Vol. IT-13, S. 260-269, April 1967).

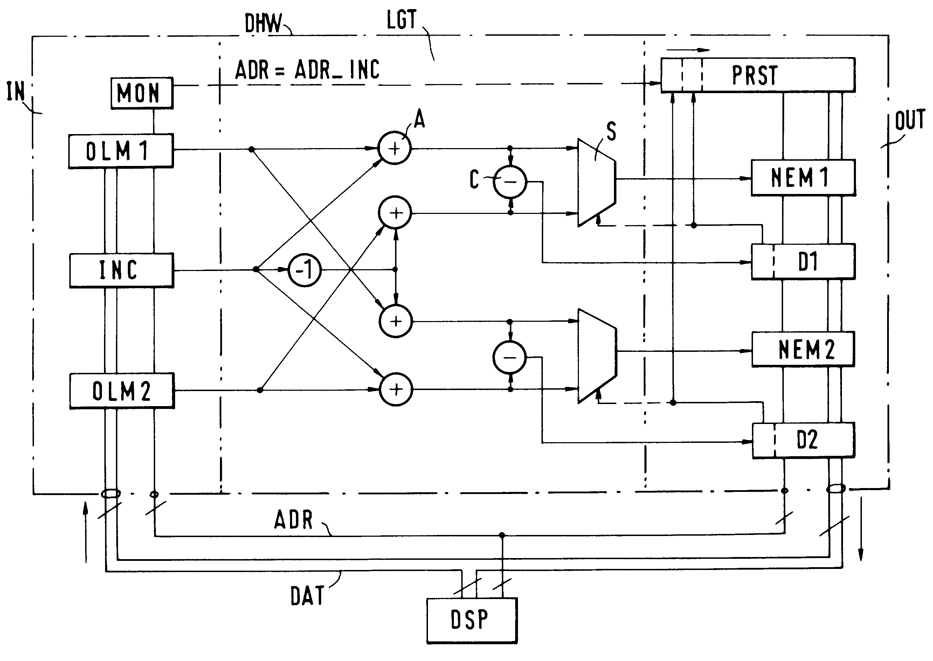

Aus EP 391 354 B1 ist ein Nachrichtenempfänger für faltungkodierte Nachrichtensignale, insbesondere für Mobilfunksignale, bekannt. Der Nachrichtenempfänger enthält eine prozessorgesteuerte Schaltungsanordnung zur Durchführung des Viterbi-Algorithmus. Diese Schaltungsanordnung enthält zwei über einen Takt gesteuerte Schaltungen: eine sogenannte Metrik-Inkrement-Einheit und eine sogenannte Addier-Vergleich- und Auswähl-Einheit (TMU bzw. ACS in Fig. 3).

Die Metrik-Inkrement-Einheit TMU errechnet entsprechend einem (zweiten) Teil des Viterbi-Algorithmus die Metrik-Inkremente für alle möglichen Übergänge. Die Addier-Vergleich-Auswähl-Einheit ACS errechnet anschließend entsprechend einem anderen (ersten) Teil des Viterbi-Algorithmus neue Metriken (s. S. 8, Zeilen 35-56). Es ist in EP 391 354 B1 weiterhin beschrieben, daß die ACS-Einheit spätere Ermittlung des überlebenden Pfads ("surviver path") innerhalb eines Netz- oder Trellisdiagrammes durchführt. Diese Pfadermittlung erfolgt entsprechend dem sogenannten Soft-Decision-Viterbi-Algorithmus. Die den Algorithmus durchführenden Einheiten TMU und ACS bilden zusammen mit einem sogenannten Pfad-RAM eine taktgesteuerte Pipeline-Struktur. Demnach ist eine mit den Einheiten verbundene Taktschaltung erforderlich. Weiterhin ist für die beiden Einheiten TMU und ACS zumindest ein Prozessor zur Durchführung des jeweiligen Algorithmusteils erforderlich. Wird ein einzelner Prozessor verwendet, so muß dieser sehr leistungsfähig sein um für beide Einheiten TMU und ACS zu arbeiten. Werden zwei Prozessoren für die beiden Einheiten verwendet, so müssen diese Prozessoren aneinander angepaßt sein, was eine mögliche Auswahl der Prozessortypen einschränkt.

Aufgabe der Erfindung ist es eine Schaltung zur teilweisen Durchführung eines Viterbi-Algorithmus in einem Nachrichtenempfänger vorzustellen, die selbst keinen Prozessor benötigt und die mit einem beliebigen Prozessor, der einen Teil des Viterbi-Algorithmus durchführt, verbindbar ist, um den verbleibenden Teil des Viterbi-Algorithmus durchzuführen.

Weiterhin sollen eine Viterbi-Dekodiereinrichtung und ein Nachrichtenempfänger vorgestellt werden, die jeweils eine solche Schaltung enthalten.

Die Aufgabe der Erfindung wird gelöst durch eine Schaltung nach Anspruch 1, durch eine Viterbi-Dekodiereinrichtung nach Anspruch 10 sowie durch einen Nachrichtenempfänger nach Anspruch 12.

Demnach ist die Schaltung mittels eines Datenbusses sowie eines Adressbusses mit einem Prozessor verbindbar. Sie enthält Speichermittel zum Speichern von Eingangs- und Ausgangsdaten. Weiterhin enthält die Schaltung eine Logikschaltung , die aus den Eingangsdaten, die der Prozessor vorgibt, die Ausgangsdaten bildet, auf die der Prozessor zugreift. Somit führt die Schaltung selbst Operationen innerhalb des Viterbi-Algorithmus durch, um den Prozessor zu entlasten. Die Schaltung benötigt keine Taktsteuerung, die auf den Prozessortakt synchronisiert ist. Die Schaltung wird durch den Zugriff des Prozessors auf die Speichermittel, d.h. beim Einlesen und Aus lesen der Eingangs- bzw. Ausgangsdaten, gesteuert.

Die Schaltung ist einfach mit einem beliebigen Prozessor zu einer Viterbi-Dekodiereinrichtung erweiterbar. Ein mit dieser Schaltung ausgestatteter Nachrichtenempfänger ist besonder gut als mobiler Funkempfänger geeignet, da die Schaltung selbst einen geringen Stromverbrauch hat. Dadurch, daß der Prozessor entlastet wird, wird auch dessen Stromverbrauch niedrig gehalten.

Vorteilhafte Ausgestaltungen der Erfindung sind den Unteransprüchen zu entnehmen.

Im folgenden wird die Erfindung anhand eines Ausführungsbeispiels und unter Zuhilfenahme einer Zeichnung beschrieben, die schematisch den Aufbau der erfindungsgemäßen Schaltung zeigt.

Die Fig. zeigt eine Schaltung DHW, die über einen Datenbus DAT und über einen Adressbus ADR mit einem digitalen Signalprozessor DSP verbunden ist. Der Datenbus und der Adressbus sind hier in einem 16 bit breitem Daten- und Adressbus integriert. Der digitale Signalprozessor ist vom Typ "TMS 320 C40", den die Firma Texas Instuments herstellt und vertreibt.

Die in der Fig. schematisch dargestellte Schaltung DHW enthält mit dem Datenbus DAT und dem Adressbus ADR verbundene erste Speichermittel IN und zweite Speichermittel OUT zum Speichern von Eingangsdaten bzw. Ausgangsdaten. Die Speichermittel sind in Flip-Flop-Technik aufgebaute Gatterschaltungen. Drei der Gatterschaltungen bilden die ersten Speichermittel IN zum Speichern von 16-bit-wertigen Eingangsdaten OLM1, OLM2 und INC, die der Prozessor DSP vorgibt. Fünf der Gatterschaltungen bilden die zweiten Speichermittel OUT zum Speichern von 16-bit-wertigen Ausgangsdaten NEM1, NEM2, D1, D2 und PRST, auf die der Prozessor zugreift. Diejenige Gatterschaltung, die das Ausgangsdatum PRST speichert, ist als Schieberegister ausgeführt. Die Schaltung DHW enthält weiterhin eine zwischen die ersten und zweiten Speichermittel geschaltete Logikschaltung LGT, die aus miteinander verschalteten Gattern aufgebaut ist und die zur Ermittlung der Ausgangsdaten die Eingangsdaten mittels Addieroperationen A, Vergleichsoperationen C und Auswahloperationen S miteinander verknüpft. Die Arbeitsweise der Schaltung DHW wird im folgenden beschrieben:

Der Prozessor DSP gibt als Eingangsdaten eine erste Metrik OLM1, eine zweite Metrik OLM2 und ein Inkrement INC vor. Die beiden Metriken OLM1 und OLM2 sind Maßzahlen für zwei Zustände innerhalb eines Trellis-Diagramms, das einem faltungscodierten Nachrichtensignal zugeordnet sind. Diese Metriken betreffen den zuletzt betrachteten Zustand und werden hier im weiteren "alte Metriken" OLM1 und OLM2 genannt. Aus diesen beiden alten Metriken bildet die Logikschaltung LGT zwei neue Metriken NEM1 und NEM2 sowie zwei Differenzwerte D1 und D2, die den nachfolgenden Zustand betreffen. Weiterhin wird der Inhalt des Schieberegisters, d.h. das Ausgangsdatum PRST, verändert. Die obigen Ausgangsdaten NEM1, NEM2, D1, D2 und PRST werden mittels logischer Verknüpfung der Eingangsdaten OLM1, OLM2 und INC nach folgenden Rechenvorschriften gebildet:
(1) NEM1 = Max [(OLM1 + INC), (OLM2 - INC)]
(2) NEM2 = Max [(OLM1 - INC), (OLM2 + INC)]
(3) D1 = (OLM1 + INC) - (OLM2 - INC)
(4) D2 = (OLM1 - INC) - (OLM2 + INC)
(5) PRST = [Bit15, Bit14, ..., Bit 2, Bit1]
wobei:
Bit15 = MSB (D2) und Bit14 = MSB (D1).
MSB: höchstwertiges Bit (Most Significant Bit).

Demnach wird die neue Metrik NEM1 oder NEM2 gebildet durch eine additive Verknüpfung der alten Metriken OLM1 und OLM2 mit dem Inkrement INC und durch eine anschließende Selektion des maximalen Wertes aus den beiden Verknüpfungsergebnissen. Somit geben die neuen Metriken für den nachfolgenden Zustand die beiden Zustandswahrscheinlichkeiten an, die die größten Beträge haben. Diese neuen Metriken NEM1 und NEM2 können als sogenannte Hard-Decision-Werte für eine spätere prozessorgesteuerte Berechnung genutzt werden. In diesem Ausführungsbeispiel werden zusätzlich zu den neuen Metriken die beiden Differenzwerte D1 und D2 gebildet. Der Differenzwert D1 oder D2 ist ein Wichtungswert für die neue Metrik NEM1 bzw. NEM2, der angibt um wieviel größer die maximale Zustandswahrscheinlichkeit (z.B. NEM1 = OLM1 + INC) als die andere Zustandswahrscheinlichkeit (hier: OLM2 - INC) ist. Somit dienen die Differenzwerte D1 und D2 für eine sogenannte Soft-Decision-Entscheidung, die der Prozessor DSP durchführt.

Zuvor werden jedoch die Metriken für alle zu betrachtenden Zustände, wie oben angegeben, ermittelt. Dazu wird die logische Verknüpfung der Eingangsdaten zyklisch durchlaufen. In diesem Beispiel werden zur Berechnung eines mit 16 möglichen Zuständen kodierten Nachrichtensignals (16-state-Viterbi) achtmal jeweils aus zwei alten Metriken und einem Inkrement zwei neue Metriken und zwei Differenzen gebildet. Dabei führt die Logikschaltung alle Berechnungen durch. Der Prozessor DSP wird entlastet und braucht lediglich das Einlesen und Auslesen der Eingangsdaten bzw. der Ausgangsdaten in die Speichermittel zu steuern. Somit führt der Prozessor DSPO im wesentlichen nur einfache Operationen wie "Move" und "Address" aus. In diesem Beispiel beträgt die Anzahl n der Metriken, die innerhalb eines Zyklus berechnet werden, gleich 2 (n = 2). Somit ist n ein ganzer Teil der Wertigkeit m = 4 des Faltungscodes, dessen Gedächtnislänge 16 = 2^{m} beträgt.

Innerhalb eines jeden Berechnungszyklus wird der Inhalt des Schieberegisters (Ausgangsdatum PRST) um zwei Bit so verschoben, daß die beiden höchstwertigen Bitstellen freiwerden. Dann wird in die höchstwertige Bitstelle das höchstwertige Bit des Differenzwertes D2 eingetragen. Die zweithöchste Bitstelle im Schieberegister wird mit dem höchstwertigen Bit des anderen Differenzwertes D1 besetzt. Der Vorgang des Bitschiebens wird durch einen Adressdetektor MON gesteuert, der den Adressbus ADR überwacht, um die Adresse für das Inkrement ADR_INC zu erkennen. Das 16-stellige Schieberegister ist demnach ein Pufferspeicher, in dem eine Bitfolge abgelegt ist, die Angaben zu den 16 Zuständen des jeweils letzten Schritts enthält. Dieser Pufferspeicher wird daher im weiteren "Prestate-Buffer" genannt.

Wurden z.B. 228 Schritte zyklisch durchlaufen, so folgt eine Berechnung desjenigen Pfads im Trellis-Diagramm, der eine Bitfolge angibt, die mit größter Wahrscheinlichkeiten gesendet wurde. Dazu wertet der Prozessor DSP alle entsprechenden Ausgangsdaten aus, d.h. in diesem Beispiel 228 Worte, die jeweils 16 Bit haben und die im Pufferspeicher abgelegt sind. Die Berechnung des Pfades kann ohne Hilfe der errechneten Differenzwerte D1 und D2, d.h. als sogenannte Hard-Decision-Berechnung, oder mit Hilfe der Differenzwerte, d.h. als sogenannte Soft-Decision-Berechnung, erfolgen.

Die beschriebene Schaltung DHW entlastet den Prozessor DSP, indem sie einen großen Teil des Viterbi-Algorithmus, nämlich die sogenannten "Add-Compare-Select"-Operationen, durchführt. Die Schaltung DHW ist einfach mittels Daten- und Adressbus mit dem Prozessor DSP verbindbar. Eine externe Taktversorgung für die Schaltung DHW ist nicht erforderlich. Weiterhin arbeitet die Schaltung durch die eingesetzten Gatterschaltungen sehr schnell. Die Schaltung DHW und der Prozessor DSP können in einem Halbleiterbaustein integriert werden. Die beschriebene Schaltung berechnet Metriken, die Maßzahlen für verschiedene Zustände innerhalb eines Trellisdiagramms sind. Es ist auch denkbar, daß die Schaltung andere Maßzahlen, wie etwa Fehlerquadrate, berechnet.

Das beschriebene Ausführungsbeispiel betrifft den Einsatz der Erfindung als Viterbi-Dekoder in einem Mobilfunkempfänger. Es sind zahlreiche andere Ausführungsbeispiele denkbar, wie etwa ein Demodulator in einem Satellitenfunkempfänger.

## Patentansprüche

1. Schaltung (DHW) zur Durchführung eines ersten Teils des Viterbi-Algorithmus in einem Nachrichtenempfänger, wobei der erste Teil Addier-, Vergleichs- und/oder Auswahloperationen (A, C, S) umfaßt,
**dadurch gekennzeichnet**, daß die Schaltung (DHW) mittels eines Datenbusses (DAT) und eines Adressbusses (ADR) mit einem Prozessor (DSP) verbindbar ist, der einen zweiten Teil (den verbleibenden Teil) des Viterbi- Algorithmus durchführt, daß die Schaltung (DHW) mit dem Datenbus und dem Adressbus verbundene erste und zweite Speichermittel (IN; OUT) enthält zum Speichern von Eingangsdaten (OLM1, OLM2, INC), die der Prozessor vorgibt bzw. zum Speichern von Ausgangsdaten (NEM1, NEM2, D1, D2, PRST), auf die der Prozessor zugreift, und daß die Schaltung (DHW) eine mit den Speichermitteln (IN; OUT) verbundene Logikschaltung (LGT) enthält, die durch logisches Verknüpfen der Eingangsdaten (OLM1, OLM2, INC) die Ausgangsdaten (NEM1, NEM2, D1, D2, PRST) bildet, wodurch die Schaltung (DHW) den ersten Teil des Viterbi-Algorithmus durchführt.

2. Schaltung (DHW) nach Anspruch 1,
gekennzeichnet durch ein Mittel (MON) zum Überwachen des Adressbusses (ADR), das zur schrittweisen Durchführung des Viterbi-Algorithmus eine Adresse (ADR_INC) detektiert, die einem der Eingangsdaten (INC) zugeordnet ist.

3. Schaltung (DHW) nach Anspruch 1,
dadurch gekennzeichnet, daß die Logikschaltung (LGT) miteinander verschaltete Gatter enthält, die die Addier-, Vergleichs- und/oder Auswahloperationen (A, C, S) innerhalb des Viterbi-Algorithmus durchführen.

4. Schaltung (DHW) nach Anspruch 1,
dadurch gekennzeichnet, daß die Eingangsdaten mindestens zwei Maßzahlen (OLM1, OLM2) für verschiedene Zustände eines faltungscodierten Nachrichtensignals angeben und ein Inkrement (INC) umfassen, und daß die Logikschaltung (LGT) durch logisches Verknüpfen der Eingangsdaten die Ausgangsdaten bildet, die mindestens eine neue Maßzahl (NEM1, NEM2) umfassen zur Auswertung innerhalb des Prozessors (DSP) und zur Verwendung als Eingangsdatum für eine spätere logische Verknüpfung innerhalb der Logikschaltung (LGT).

5. Schaltung (DHW) nach Anspruch 4, dadurch gekennzeichnet, daß die Maßzahlen Metriken (OLM1, OLM2; NEM1, NEM2) oder Fehlerquadrate sind, die einem Zustandsdiagramm für das faltungscodierte Nachrichtensignal zugeordnet sind.

6. Schaltung (DHW) nach Anspruch 4,
dadurch gekennzeichnet, daß Logikschaltung (LGT) durch logisches Verknüpfen der Eingangsdaten (OLM1, OLM2, INC) die Ausgangsdaten bildet, die weiterhin mindestens einen Wichtungswert (D1, D2) umfassen zur Auswertung der mindestens einen neuen Maßzahl (NEM1, NEM2) mittels einer gewichteter Entscheidung (Soft-Decision) innerhalb des Prozessors (DSP).

7. Schaltung (DHW) nach Anspruch 4,
dadurch gekennzeichnet, daß die Eingangsdaten und die Ausgangsdaten jeweils eine Anzahl Metriken (OLM1, OLM2; NEM1, NEM2) umfassen, die an die Wertigkeit eines Faltungscodes angepaßt ist.

8. Schaltung (DHW) nach Anspruch 6,
dadurch gekennzeichnet, daß die Logikschaltung (LGT) aus dem höchstwertigen Bit (MSB) des mindestens einen Wichtungswertes (D1, D2) ein Ausgangsdatum (PRST) bildet für eine von dem Prozessor (DSP) gesteuerte Berechnung eines Pfads, der in einem Zustandsdiagramm für das vom Nachrichtenempfänger empfangenen Nachrichtensignal eine Bitfolge angibt, die mit größter Wahrscheinlichkeit gesendet worden ist.

9. Schaltung (DHW) nach Anspruch 1,
dadurch gekennzeichnet, daß die Speichermittel (IN; OUT) verschiedenen Speicherbereichen, insbesondere verschiedenen Registern, eines mittels Gattern aufgebauten Speichers entsprechen, auf den der Prozessor (DSP) zugreift.

10. Viterbi-Dekodiereinrichtung für einen Nachrichtenempfänger, die eine Schaltung (DHW) zur Durchführung eines ersten Teils des Viterbi-Algorithmus enthält, wobei der erste Teil Addier-, Vergleichs- und/oder Auswahloperationen (A, C, S) umfaßt, **dadurch gekennzeichnet**, daß die Viterbi-Dekodiereinrichtung einen Prozessor (DSP) enthält, der einen zweiten Teil (den verbleibenden Teil) des Viterbi-Algorithmus durchführt, daß die Schaltung (DHW) mittels eines Datenbusses (DAT) und eines Adressbusses (ADR) mit dem Prozessor (DSP) verbunden ist, daß die Schaltung (DHW) mit dem Datenbus und dem Adressbus verbundene erste und zweite Speichermittel (IN; OUT) enthält zum Speichern von Eingangsdaten (OLM1, OLM2, INC), die der Prozessor vorgibt, bzw. zum Speichern von Ausgangsdaten (NEM1, NEM2, D1, D2, PRST), auf die der Prozessor zugreift, und daß die Schaltung (DHW) eine mit den Speichermitteln (IN; OUT) verbundene Logikschaltung (LGT) enthält, die durch logisches Verknüpfen der Eingangsdaten (OLM1, OLM2, INC) die Ausgangsdaten (NEM1, NEM2, D1, D2, PRST) bildet, wodurch die Schaltung (DHW) den ersten Teil des Viterbi-Algorithmus durchführt.

11. Viterbi-Dekodiereinrichtung nach Anspruch (10), dadurch gekennzeichnet, daß der Prozessor (DSP) und die Schaltung (DHW) in einen Halbleiterbaustein integriert sind.

12. Nachrichtenempfänger, insbesondere Funkempfänger, mit einer Viterbi-Dekodiereinrichtung, die eine Schaltung (DHW) zur Durchführung eines ersten Teils des Viterbi-Algorithmus enthält, wobei der erste Teil Addier-, Vergleichs- und/oder Auswahloperationen (A, C, S) umfaßt,
**dadurch gekennzeichnet**, daß die Viterbi-Dekodiereinrichtung einen Prozessor (DSP) enthält, der einen zweiten Teil (den verbleibenden Teil) des Viterbi-Algorithmus durchführt, daß die Schaltung (DHW) mittels eines Datenbusses (DAT) und eines Adressbusses (ADR) mit dem Prozessor (DSP) verbunden ist, daß die Schaltung (DHW) mit dem Datenbus und dem Adressbus verbundene erste und zweite Speichermittel (IN; OUT) enthält zum Speichern von Eingangsdaten (OOM1, OLM2, INC), die der Prozessor vorgibt, bzw. zum Speichern von Ausgangsdaten (NEM1, NEM2, D1, D2, PRST), auf die der Prozessor zugreift, und daß die Schaltung (DHW) eine mit den Speichermitteln (IN; OUT) verbundene Logikschaltung (LGT) enthält, die durch logisches Verknüpfen der Eingangsdaten (OLM1, OLM2, INC) die Ausgangsdaten (NEM1, NEM2, D1, D2, PRST) bildet, wodurch die Schaltung (DHW) den ersten Teil des Viterbi-Algorithmus durchführt.
